# FASCICULE DE BREVET EUROPEEN

(11) **EP 4 020 011 B1**
(45) Date de publication et mention de la délivrance du brevet: **03.09.2025**
(21) Numéro de dépôt: 21216644.1
(22) Date de dépôt: 21.12.2021
(51) Int. Cl.: G01S 13/78, G01S 13/87, G01S 13/91, G01S 7/282, G01S 7/03

(54) **DISPOSITIF D'ÉMISSION RADIO D'UN SIGNAL D'INTERROGATION À PARTIR D'UN SIGNAL À AMPLIFIER**
VORRICHTUNG ZUR FUNKÜBERTRAGUNG EINES ABFRAGESIGNALS AUS EINEM ZU VERSTÄRKENDEN SIGNAL
DEVICE FOR RADIO TRANSMISSION OF A SIGNAL FOR QUERYING FROM A SIGNAL TO BE AMPLIFIED

(30) Priorité: 23.12.2020 FR 2013991
(43) Date de publication de la demande: 29.06.2022
(73) Titulaire: THALES, 92190 Meudon (FR)
(72) Inventeur: HOGOMMAT-CHABROT, Laure, 53005 Laval (FR); GELY, Jean-René, 92622 Genevilliers (FR)
(74) Mandataire: Atout PI Laplace

(56) Documents cités:
- EP-A1- 3 337 045
- US-A1- 2005 156 777

## Description

### Domaine technique

La présente invention se situe dans le domaine des émissions RF (acronyme de radiofréquence) par impulsions, et porte plus précisément sur le contrôle du spectre d'émission de telles modulations. Elle s'applique en particulier aux modulations par impulsions utilisées dans le cadre des communications IFF (pour « Interrogation Friend and Foe » en anglais ou identification ami ou ennemi en français).

### Technique antérieure

Les transmissions IFF sont des transmissions utilisées en aéronautique dans la gamme de fréquence [1030 MHZ - 1090 MHZ] pour permettre aux radars d'approche, tant civils que militaires, de reconnaître des avions « amis » et de déterminer leur cap et leur distance. Les émissions IFF sont basées sur des trains d'impulsions transmis à forte puissance. Les communications IFF peuvent se faire selon différents modes (civils selon l'OACI annexe 10 (pour « International Civil Aviation Organization ») et militaires selon le STANAG 4193 (pour « NATO Standardization Agreements » en anglais, ou accords de normalisation en français), et diffèrent selon que l'on se trouve en interrogation ou en réponse. Les informations sont transmises en faisant varier la largeur des impulsions, leurs écarts relatifs, et/ou en introduisant aux impulsions une couche de modulation (typiquement une modulation DPSK (pour « Differential Phase Shift Keying » en anglais) ou MSK (pour « Minimum Shift Keying » en anglais). Les largeurs des impulsions et les écarts entre impulsions sont typiquement de l'ordre de quelques centaines de nano secondes.

Les émissions IFF sont soumises à des contraintes importantes, définies entre autres par l'AIMS 03-1000b (pour « Air traffic control radar beacon system Identification friend and foe », Mark XII/XIIA System du département de la défense Américain), l'OACI annexe 10 volume IV, l'EUROCAE ED-73F (pour EUROpean Organisation for Civil Aviation Equipment), ou la norme DO260C du RTCA (pour « Radio Technical Commission for Aeronautics » en anglais), telle que RTCA DO-386 et RTCA DO181F (Mode S) compatibles avec le système d'évitement de collision aéroporté X (ACAS-X (pour « Airborne Collision Avoidance System » X en anglais)). Ces normes définissent entre autres les gabarits spectraux et temporels que doivent respecter les impulsions des émissions IFF.

Le document EP3337045 divulgue un dispositif d'émission radio d'un signal émis sous la forme d'une séquence d'impulsions. Ce dispositif comprend une partie de génération des impulsions sur fréquence porteuse et une chaîne analogique d'amplifications des impulsions avant leur émission. Cette chaîne d'amplification comprend une pluralité d'étages d'amplification successifs. Ce dispositif comprend un module de génération d'un signal de commande de forme sensiblement trapézoïdale. Ce signal de commande est appliqué en tant que tension de polarisation d'un amplificateur d'un étage de la chaîne d'amplification pour chacune des impulsions. Il est ainsi possible de contrôler le gabarit spectral du signal impulsionnel émis en modulant la polarisation d'un des amplificateurs de la chaîne d'amplification. Cette technique de contrôle est appelée « pulse shaping ». Elle remplace notamment le filtrage passe bande qui présente de nombreux inconvénients en terme de performance (pas de filtrage in-band, dégradation de l'EVM (pour « Error Vector Magnitude » en anglais) et dispersion en température), en terme de consommation (augmentation de la puissance de la chaîne pour compenser les pertes), en terme de fiabilité (impact du « return loss out band » sur les transistors et difficulté de réalisation du filtre) et en terme de coûts (composants coûteux). Le « pulse shaping » permet d'adresser avantageusement ces problèmes, mais n'a pour l'instant appliqué qu'à des chaines mono-fréquence.

Dès lors, si l'on souhaite délivrer deux types de signaux différents, par exemple, un signal à 1090 MHZ pour une fonction transpondeur Mode S ou un signal à 1030 MHZ pour une fonction TCAS, il faut mettre en place deux chaînes d'émissions séparées. Par « transpondeur Mode S », on entend un mode d'interrogation utilisé pour obtenir un certain nombre d'informations sur les avions équipés du système. Par « TCAS » (pour « Traffic Alert and Collision Avoidance System »), on entend un système interrogatif et coopératif qui questionne les transpondeurs des avions proches sur la fréquence 1030 MHZ. Ainsi, la fonction transpondeur Mode S et la fonction TCAS permettent de délivrer des signaux d'interrogation. Cependant, chacune de ces chaînes d'émission présente un poids et un volume propre. L'association de ces deux chaînes d'émission peut alors être incompatible dans des aéronefs de petite taille. En outre, la consommation n'est pas optimisée, ce qui est inconvénient majeur pour applications drones.

US 2005/156777 A1 décrit une solution permettant de combiner les fonctionnalité à la fois d'un système de surveillance du trafic et d'évitement des collisions (TCAS) et d'un transpondeur à sélection de mode dans un dispositif de surveillance du trafic à bande L.

Il existe donc un besoin de proposer un dispositif d'émission radio d'un signal d'interrogation qui puisse émettre différents types de signaux sur différentes fréquences compatibles avec les normes actuelles concernant les communications IFF.

### Exposé de l'invention

La présente invention vise à remédier au moins en partie à ce besoin.

Plus particulièrement, la présente invention vise à améliorer l'encombrement d'un dispositif d'émission radio d'un signal d'interrogation, tout en le rendant compatible à l'émission de différents types de signaux d'interrogation.

Un premier objet de l'invention concerne un dispositif d'émission radio d'un signal d'interrogation à partir d'un signal à amplifier, ledit signal d'interrogation comportant une pluralité d'impulsions. Le dispositif d'émission radio comprend un générateur d'un signal à amplifier avec un dispositif de pré-distorsion des impulsions du signal à amplifier sur fréquence porteuse, une seule chaîne d'amplification de puissance du signal à amplifier pour former un signal d'interrogation, un module d'interfaces adapté pour générer un signal trapézoïdal appliqué en tant que tension de polarisation dans la chaîne d'amplification de puissance pour émettre chacune des impulsions dudit signal d'interrogation. Le dispositif d'émission radio comprend un bloc de sélection d'un type de signal d'interrogation à émettre parmi au moins deux types de signaux d'interrogation différents. Le générateur de signal à amplifier est configuré de sorte à permettre l'émission d'un signal à amplifier, pour la génération du signal d'interrogation correspondant au type de signal d'interrogation sélectionné.

Ainsi, il est possible d'obtenir un équipement avec une chaîne bi-fréquence. Le bloc de sélection est adapté pour sélectionner le type de signal d'interrogation à émettre. Cette sélection est, par exemple, une sélection automatique sous la forme d'une gestion des priorités entre les fonctionnalités TCAS et le répondeur IFF. La commutation rapide d'une fréquence à l'autre et la gestion de priorités, notamment par l'intermédiaire d'un logiciel, entre ces fonctionnalités TCAS et le répondeur IFF permettent de répondre à l'ensemble des contraintes normatives avec une seule chaîne d'émission.

Dans un mode de réalisation particulier, selon un premier type de signal d'interrogation à émettre, le générateur de signal à amplifier est configuré comme un transpondeur mode S pour l'émission d'un signal d'interrogation de 1090 MHz.

Un mode d'interrogation de transpondeur aéronautique est le format que prend une série d'impulsions émise par un radar secondaire ou un système équivalent, et le format, ou code, de la réponse de ce transpondeur. Ce mode d'interrogation est utilisé pour obtenir des informations sur les avions équipés du système. Dans sa forme la plus simple, un mode est généralement déterminé par l'espacement entre deux ou plusieurs impulsions d'interrogation. Il existe différents modes, 1 à 5 pour les militaires et A, B, C, D et le mode S pour l'usage civil. Le mode S retourne divers formats d'information sur une interrogation sélective. Chaque avion se voit attribuer une adresse fixe codée sur 24 bits.

Dans un mode de réalisation particulier, selon un second type de signal d'interrogation à émettre, le générateur de signal à amplifier est configuré comme un système d'alerte de trafic et d'évitement de collision pour l'émission d'un signal d'interrogation de 1030 MHz.

Le système utilisant un signal TCAS est un système interrogatif et coopératif qui questionne les transpondeurs des avions proches. Le système TCAS interroge toutes les secondes environ tous les avions dans sa zone de détection. En fonction des réponses, le système TCAS est capable de déterminer la position de ceux-ci en deux ou trois dimensions.

C'est la combinaison de la pré-distorsion du signal en amplitude et de la modulation de la tension de polarisation d'un avant dernier transistor (pulse shaping) qui permet de contrôler à la fois l'aspect temporel et le gabarit spectral du signal impulsionnel sur la même chaîne d'émission à la fois à la fréquence répondeur IFF et à la fois à la fréquence d'émission interrogateur IFF/TCAS.

Dans un mode de réalisation particulier, le dispositif de pré-distorsion comprend un circuit logique programmable adapté pour piloter une adaptation d'une phase et d'une amplitude du signal à amplifier, un convertisseur numérique-analogique d'un signal IQ, un modulateur du signal IQ avec synthétiseur intégré.

Dans un mode de réalisation particulier, le circuit logique programmable comprend un module de contrôle adapté pour le contrôle de la pré-distorsion, un module de commande de pré-distorsion, un module d'adaptation d'amplitude et de phase.

Dans un mode de réalisation particulier, le module de contrôle effectue un contrôle à partir d'une pluralité de paramètres tels qu'une fréquence, une puissance et/ou une température.

Un autre objet de l'invention concerne un procédé d'émission radio d'un signal d'interrogation à partir d'un signal à amplifier, ledit signal d'interrogation comportant une pluralité d'impulsions. Le procédé comporte une étape de génération d'un signal à amplifier et de pré-distorsion des impulsions du signal à amplifier sur fréquence porteuse, une étape d'amplification en puissance du signal à amplifier pour former un signal d'interrogation, une étape de génération d'un signal trapézoïdal appliqué en tant que tension de polarisation au cours de l'étape d'amplification en puissance pour émettre chacune des impulsions dudit signal d'interrogation. Le procédé d'émission radio est mis en œuvre dans un dispositif d'émission comprenant une seule chaîne d'amplification du signal et comporte en outre une étape de sélection d'un type de signal d'interrogation à émettre parmi au moins deux types de signaux différents, l'étape d'amplification en puissance du signal à amplifier étant configuré de sorte à permettre l'émission d'un signal à amplifier pour la génération du signal d'interrogation correspondant au type de signal d'interrogation sélectionné.

Un autre objet de l'invention concerne un transpondeur comportant un dispositif d'émission radio selon l'un des objets précédents.

Un autre objet de l'invention concerne un ACAS-X comportant un dispositif d'émission radio selon l'un des objets précédents.

Un autre objet de l'invention concerne un programme d'ordinateur comportant des instructions de programme exploitables par un dispositif d'émission radio adapté pour émettre un signal d'interrogation à partir d'un signal à amplifier selon un des objets précédents qui lorsqu'elles sont exécutées ou interprétées par ledit dispositif d'émission déclenchent la mise en œuvre du procédé d'émission radio du signal d'interrogation selon un des objets précédents.

La présente invention sera mieux comprise à la lecture de la description détaillée de modes de réalisation pris à titre d'exemples nullement limitatifs et illustrés par les dessins annexés sur lesquels :
La figure 1 est une vue schématique d'un dispositif d'émission radio d'un signal d'interrogation selon l'invention ;
La figure 2 est une vue schématique détaillée d'un générateur d'un signal à amplifier du dispositif d'émission radio de la figure 1 ;
La figure 3 est une vue schématique détaillée d'un dispositif de pré-distorsion du générateur de signal à amplifier de la figure 2 ;
La figure 4 illustre les étapes d'un procédé d'émission radio d'un signal d'interrogation selon l'invention.

Sur les différentes figures, les éléments identiques ou similaires portent les mêmes références.

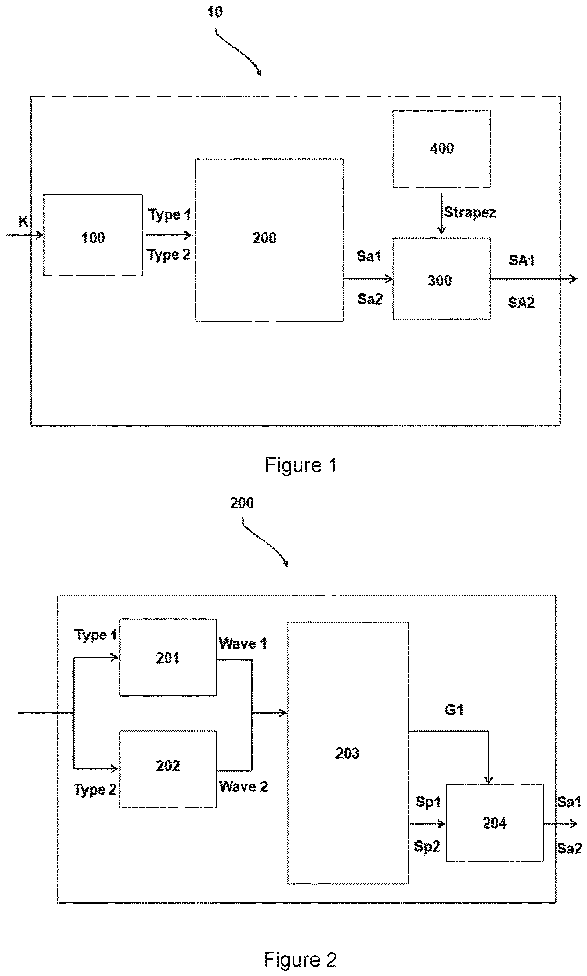

La figure 1 illustre un dispositif d'émission radio 10 d'un signal d'interrogation selon l'invention.

Ce dispositif d'émission radio 10 comprend :
- un bloc de sélection 100 ;
- un générateur 200 ;
- une chaîne d'amplification de puissance 300 ;
- un module d'interfaces 400.

Le bloc de sélection 100 est apte à recevoir une commande K. A partir de cette commande K, le bloc de sélection 100 informe sur le type de signal Type 1, Type 2 à émettre.

Le générateur 200 est apte à recevoir une information sur le type de signal Type 1 ou Type 2 à émettre et à délivrer un signal à amplifier Sa1 ou Sa2. Le signal à amplifier Sa1 est associé au type de signal Type 1 et le signal à amplifier Sa2 est associé au type de signal Type 2.

La chaîne d'amplification de puissance 300 est adaptée pour amplifier le signal à amplifier Sa1 ou Sa2 en vue de former un signal d'interrogation SA1 ou SA2. Le signal d'interrogation SA1 est associé au signal à amplifier Sa1 et le signal d'interrogation SA2 est associé au signal à amplifier Sa2. Cette chaîne d'amplification comporte au moins deux transistors (non représentés sur la figure 1). L'amplification du signal est ainsi réalisée par plusieurs étages d'amplification successifs, afin d'augmenter progressivement l'amplitude et la puissance des impulsions sans y introduire de bruit.

Le module d'interfaces 400 est adapté pour générer un signal trapézoïdal Strapez destiné à être appliqué en tant que tension de polarisation dans la chaîne d'amplification de puissance 300 pour émettre chacune des impulsions du signal d'interrogation SA1, SA2. Dans un mode de réalisation particulier non représenté sur la figure 1, ce module d'interfaces 400 comprend deux blocs de génération de signaux de contrôle de grille adaptés pour mettre en œuvre un gain adaptatif, un bloc de génération de pulse shaping adapté pour générer le signal trapézoïdal Strapez de sorte à permettre un gain adaptatif et des bords de signaux adaptatifs. Le module d'interfaces 400 permet l'utilisation du pulse shaping, c'est-à-dire la variation de la tension de polarisation de l'un des amplificateurs de la chaîne d'émission sur les périodes correspondant aux fronts montants et descendants des impulsions, afin de les mettre en forme de manière à respecter un gabarit spectral et des performances RF associées (temps de montée et de descente, bruit inter-pulse, respect de la réglementation ITU pour un train d'ondes en fonction de chaque fréquence, puissance et température).

On notera dès à présent que le dispositif d'émission radio 10 est ici soit configuré comme un transpondeur mode S pour l'émission d'un signal d'interrogation SA1 de 1090 MHZ soit configuré comme un système d'alerte de trafic et d'évitement de collision pour l'émission d'un signal d'interrogation SA2 de 1030 MHZ.

La figure 2 illustre plus en détail le générateur 200 de la figure 1.

Ce générateur 200 comprend :
- un bloc 201 de mise en forme d'onde IFF ;
- un bloc 202 de mise en forme d'onde TCAS ;
- un dispositif 203 de pré-distorsion ;
- un amplificateur RF 204.

Le bloc 201 est adapté pour mettre en forme une onde caractérisant un transpondeur IFF. Ce bloc 201 reçoit l'information du signal Type 1 et émet une forme d'onde Wave1 associée.

Le bloc 202 est adapté pour mettre en forme une onde caractérisant un système TCAS avec des patterns spécifiques (fonction whisper/shout) ayant des amplitudes différentes sur des pulses espacés d'une microseconde. Le bloc 302 reçoit l'information du signal Type 2 et émet une forme d'onde Wave2 associée.

Le dispositif 203 est adapté pour réaliser une pré-distorsion des impulsions du signal à amplifier sur la fréquence porteuse. Les étages successifs d'amplification ont pour effet de déformer le signal. En particulier, ils ont tendance à redresser les fronts des impulsions, ce qui a pour effet de dégrader le spectre du signal émis. Le bloc 203 de pré-distorsion permet de contenir les émissions dans le gabarit spectral et le gabarit temporel souhaités. Le bloc 203 est adapté pour recevoir la forme d'onde Wave1 ou la forme d'onde Wave2. En sortie, le bloc 203 délivre un premier signal Sp1 ayant subi une pré-distorsion sur la forme d'onde Wave1 ou un second signal Sp2 ayant subi une pré-distorsion sur la forme d'onde Wave2. Le bloc 203 délivre également un gain adaptatif G1.

L'amplificateur RF 204 est adaptée pour amplifier le premier signal Sp1 ou le second signal Sp2 à partir du gain adaptatif G1. L'amplification par l'amplificateur RF 204 est insuffisante. Cet amplificateur RF 204 va alors délivrer un premier signal à amplifier Sa1 ou un second signal à amplifier Sa2 à destination de la chaîne d'amplification de puissance 300 de la figure 1.

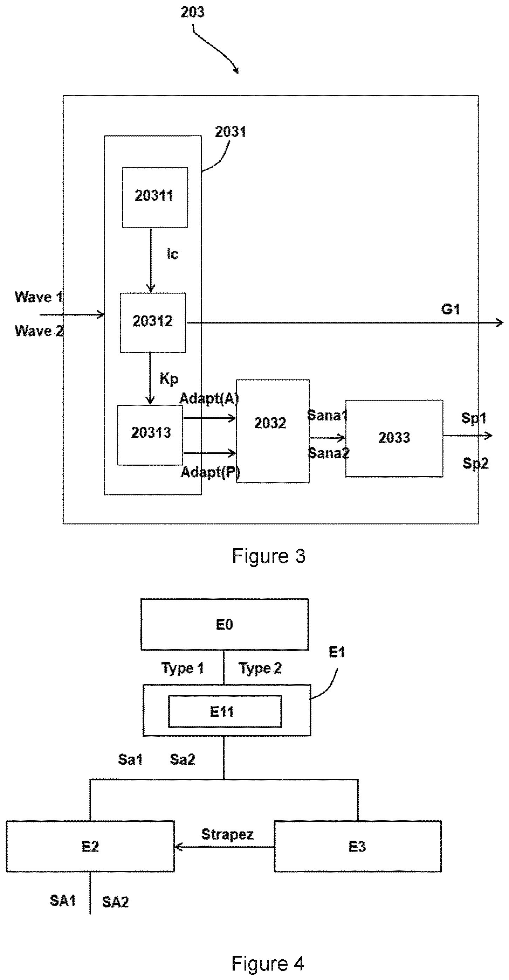

La figure 3 détaille le dispositif 203 de pré-distorsion. Ce dispositif 203 comprend :
- un circuit logique programmable 2031 ;
- un convertisseur numérique-analogique 2032 ;
- un modulateur 2033.

Le circuit logique programmable 2031 est apte à piloter une adaptation d'une phase et d'une amplitude du signal à amplifier. Il reçoit la forme d'onde Wave1 ou la forme d'onde Wave2 délivrée par le bloc 201 ou le bloc 202. Ce circuit logique programmable 2031 comprend :
- un module de contrôle 20311 adapté pour contrôler la pré-distorsion ;
- un module de commande 20312 de pré-distorsion ;
- un module d'adaptation 20313.

Le module de contrôle 20311 est adapté pour contrôler la pré-distorsion. Ce contrôle se fait à partir d'une pluralité de paramètres tels qu'une fréquence, une puissance et/ou une température. Le module de contrôle 20311 transmet une information de contrôle Ic au module de commande 20312 de pré-distorsion.

Le module de commande 20312 de pré-distorsion est adapté pour générer le gain adaptatif G1 et une commande de pré-distorsion Kp au module d'adaptation 20313 d'amplitude et de phase. Dans un mode de réalisation particulier non illustré sur la figure 3, le module de commande 20312 comprend un bloc de sélection d'oscillateur et un bloc de gain adaptatif. Le bloc de sélection d'oscillateur est apte à sélectionner une fréquence d'oscillation selon deux fréquences différentes, c'est-à-dire, ici, selon la fréquence 1090 MHZ ou la fréquence 1030 MHZ. Ce choix d'oscillation est lié à la forme d'onde Wave1 ou Wave2 reçue.

Le module d'adaptation 20313 est adapté pour effectuer une adaptation en amplitude et en phase de la forme d'onde Wave1 ou de la forme d'onde Wave2 reçue à partir de la commande de pré-distorsion Kp reçue. Ce module d'adaptation 20313 délivre alors une adaptation en amplitude Adapt(A), ou une adaptation en phase Adapt(P).

Le convertisseur numérique-analogique 2032 est adapté pour convertir un signal IQ en bande de base ou sur une fréquence intermédiaire. Il reçoit du module d'adaptation 20313 l'adaptation en amplitude et l'adaptation en phase. Ce convertisseur permet de convertir la pré-distorsion en signal analogique. Cette pré-distorsion est nécessaire pour garantir les différences d'amplitudes entre pulses d'un même train (quelques centaines de nanosecondes entre pulses) conformément aux normes. Ce convertisseur numérique-analogique 2032 est adapté pour transmettre un premier signal analogique Sana1 ou un second signal analogique Sana2 selon la forme d'onde Wave1 ou Wave2 adaptée en amplitude et en phase.

Le modulateur 2033 est adapté pour moduler le signal IQ avec un synthétiseur intégré. Plus particulièrement, ce modulateur 2033 utilise une banque préprogrammée pour générer la fréquence d'émission à commuter de fréquence en quelques microsecondes. Ce module 2033 reçoit le premier signal analogique Sana1 ou Sana2 et émet en sortie le premier signal Sp1 ou le second signal Sp2.

Un procédé d'émission radio d'un signal d'interrogation va être décrit à l'appui des figures 1 à 3 et de la figure 4.

Ce procédé d'émission radio comporte une étape E1 de génération d'un signal à amplifier Sa1, Sa2. Dans une sous-étape E11 de l'étape E1 de génération, la pré-distorsion est réalisée pour les impulsions du signal à amplifier Sa1, Sa2 sur la fréquence porteuse.

Le signal Sa1, Sa2 est ensuite amplifié dans une étape E2 d'amplification en puissance pour former le signal d'interrogation SA1, SA2.

Dans une étape E3, le signal trapézoïdal Strapez est appliqué en tant que tension de polarisation au cours de l'étape E2 d'amplification en puissance.

Dans une étape E0 préalable aux étapes E1 à E3, un type de signal d'interrogation à émettre est sélectionné parmi au moins deux types de signaux différents. Ainsi, l'étape E2 d'amplification en puissance du signal à amplifier est configurée de sorte à permettre l'émission du signal à amplifier Sa1, Sa2 pour la génération du signal d'interrogation SA1, SA2 correspondant au type Type 1, Type 2 de signal d'interrogation sélectionné.

Le dispositif radio 10 apporte les avantages suivants :
- il permet d'utiliser une seul chaîne d'émission pour les deux fréquences au lieu de deux pour assurer les fonctions répondeurs et TCAS ;
- il permet de diviser par deux le nombre d'antennes nécessaires ce qui réduit le poids le volume et la consommation ;
- il permet d'utiliser de la pré-distorsion sur les entrées IQ au lieu de la commutation sur un atténuateur pour réaliser la fonction whisper/shout ;
- il permet d'utiliser du pulse shaping numérique à la place d'un filtrage en puissance pour respecter un gabarit spectral sur une seule voie ;
- il permet de gérer les différents niveaux d'émission TCAS par contrôle des gains des premiers étages de la chaine d'amplification par programmation des composants entre les trains (1 ms en typique).

L'invention concerne également un transpondeur comportant le dispositif d'émission radio 10 ou un système d'évitement de collision aéroporté X (ACAS-X) comportant un tel dispositif d'émission 10.

L'invention concerne également un produit programme d'ordinateur comportant des instructions de programme exploitables par le dispositif d'émission radio adapté pour émettre le signal d'interrogation SA1, SA2 à partir du signal à amplifier Sa1, Sa2 qui lorsqu'elles sont exécutées ou interprétées par ledit dispositif d'émission 10 déclenchent la mise en œuvre du procédé d'émission radio du signal d'interrogation SA1, SA2.

L'invention n'est pas limitée aux modes de réalisation et variantes présentées et d'autres modes de réalisation et variantes apparaîtront clairement à l'homme du métier.

## Revendications

1. Dispositif d'émission radio (10) d'un signal d'interrogation (SA1, SA2) à partir d'un signal à amplifier (Sa1, Sa2), ledit signal d'interrogation (SA1, SA2) comportant une pluralité d'impulsions, ledit dispositif d'émission radio (10) comprenant :
- un générateur (200) d'un signal à amplifier (Sa1, Sa2) avec un dispositif (203) de pré-distorsion des impulsions du signal à amplifier (Sa1, Sa2) sur fréquence porteuse; ;
- une seule chaîne d'amplification de puissance (300) du signal à amplifier (Sa1, Sa2) pour former un signal d'interrogation (SA1, SA2) ;
- un module d'interfaces (400) apte à générer un signal trapézoïdal (Strapez) appliqué en tant que tension de polarisation dans la chaîne d'amplification de puissance (300) pour émettre chacune des impulsions dudit signal d'interrogation (SA1, SA2) ; et -un bloc de sélection (100) d'un type de signal d'interrogation à émettre parmi au moins deux types (Type 1, Type 2) de signaux d'interrogation différents,
ledit générateur (200) de signal à amplifier étant configuré de sorte à permettre l'émission d'un signal à amplifier (Sa1, Sa2), pour la génération du signal d'interrogation (SA1, SA2) correspondant au type (Type 1, Type 2) de signal d'interrogation sélectionné.

2. Dispositif d'émission selon la revendication 1, dans lequel selon un premier type (Type 1) de signal d'interrogation (SA1) à émettre, le dispositif d'émission radio (10) est configuré comme un transpondeur mode S pour l'émission d'un signal d'interrogation de 1090 MHz.

3. Dispositif d'émission selon l'une quelconque des revendications 1 ou 2, dans lequel selon un second type (Type 2) de signal d'interrogation (SA2) à émettre, le dispositif d'émission radio (10) est configuré comme un système d'alerte de trafic et d'évitement de collision pour l'émission d'un signal d'interrogation de 1030 MHz.

4. Dispositif d'émission selon l'une quelconque des revendications 1 à 3, dans lequel le dispositif de pré-distorsion (203) comprend :
- un circuit logique programmable (2031) apte à piloter une adaptation d'une phase et d'une amplitude du signal à amplifier ;
- un convertisseur numérique-analogique (2032) d'un signal IQ ;
- un modulateur (2033) du signal IQ avec synthétiseur intégré.

5. Dispositif d'émission selon la revendication 4, dans lequel le circuit logique programmable (2031) comprend :
- un module de contrôle (20311) adapté pour le contrôle de la pré-distorsion ;
- un module de commande (20312) de pré-distorsion ;
- un module d'adaptation (20313) d'amplitude et de phase.

6. Dispositif d'émission selon la revendication 5, dans lequel le module de contrôle (20311) effectue un contrôle à partir d'une pluralité de paramètres tels qu'une fréquence, une puissance et/ou une température.

7. Procédé d'émission radio d'un signal d'interrogation à partir d'un signal à amplifier (Sa1, Sa2), ledit signal d'interrogation (SA1, SA2) comportant une pluralité d'impulsions, ledit procédé comportant :
- une étape de génération (E1) d'un signal à amplifier (Sa1, Sa2) et de pré-distorsion E(11) des impulsions du signal à amplifier (Sa1, Sa2) sur fréquence porteuse;
- une étape (E2) d'amplification en puissance du signal à amplifier (Sa1, Sa2) pour former un signal d'interrogation (SA1, SA2) ;
- une étape (E3) de génération d'un signal trapézoïdal (Strapez) appliqué en tant que tension de polarisation au cours de l'étape (E2) d'amplification en puissance pour émettre chacune des impulsions dudit signal d'interrogation (SA1, SA2) ; ledit procédé d'émission radio étant mis en œuvre dans un dispositif d'émission comprenant une seule chaîne d'amplification du signal et comportant en outre :
- une étape (E0) de sélection (100) d'un type de signal d'interrogation à émettre parmi au moins deux types (Type 1, Type 2) de signaux d'interrogation différents, l'étape (E2) d'amplification en puissance du signal à amplifier étant configuré de sorte à permettre l'émission d'un signal à amplifier (Sa1, Sa2) pour la génération du signal d'interrogation (SA1, SA2) correspondant au type (Type 1, Type 2) de signal d'interrogation sélectionné.

8. Transpondeur comportant un dispositif d'émission radio (10) selon l'une quelconque des revendications 1 à 6.

9. Système d'évitement de collision aéroporté X, Airborne Collision Avoidance System X - ACAS-X, comportant un dispositif d'émission radio (10) selon l'une quelconque des revendications 1 à 6.

10. Produit programme d'ordinateur comportant des instructions de programme exploitables par un dispositif d'émission radio (10) adapté pour émettre un signal d'interrogation (SA1, SA2) à partir d'un signal à amplifier (Sa1, Sa2) selon l'une quelconque des revendications 1 à 6, qui lorsqu'elles sont exécutées ou interprétées par ledit dispositif d'émission (10) déclenchent la mise en œuvre du procédé d'émission radio du signal d'interrogation (SA1, SA2) selon la revendication 7.

## Patentansprüche

1. Funkübertragungsvorrichtung (10) eines Abfragesignals (SA1, SA2) aus einem zu verstärkenden Signal (Sa1, Sa2), wobei das Abfragesignal (SA1, SA2) eine Vielzahl von Impulsen aufweist, wobei die Funkübertragungsvorrichtung (10) Folgendes umfasst:
- einen Generator (200) für ein zu verstärkendes Signal (Sa1, Sa2) mit einer Vorverzerrungsvorrichtung (203) für die Impulse des zu verstärkenden Signals (Sa1, Sa2) auf einer Trägerfrequenz;
- eine einzige Leistungsverstärkungskette (300) des zu verstärkenden Signals (Sa1, Sa2) zum Bilden eines Abfragesignals (SA1, SA2);
- ein Schnittstellenmodul (400), das in der Lage ist, ein trapezförmiges Signal (Strapez) zu erzeugen, das als Polarisationsspannung in der Leistungsverstärkungskette (300) angelegt wird, um jeden der Impulse des Abfragesignals (SA1, SA2) zu übertragen; und
- einen Auswahlblock (100) für einen zu übertragenden Abfragesignaltyp aus mindestens zwei verschiedenen Abfragesignaltypen (Typ 1, Typ 2),
wobei der Generator für das zu verstärkende Signal (200) so konfiguriert ist, dass er die Übertragung eines zu verstärkenden Signals (Sa1, Sa2) zur Erzeugung des Abfragesignals (SA1, SA2) ermöglicht, das dem ausgewählten Abfragesignaltyp (Typ 1, Typ 2) entspricht.

2. Übertragungsvorrichtung nach Anspruch 1, wobei die Funkübertragungsvorrichtung (10) gemäß eines ersten Typs (Typ 1) eines zu übertragenden Abfragesignals (SA1) als Mode-S-Transponder zum Übertragen eines 1090 MHz-Abfragesignals konfiguriert ist.

3. Übertragungsvorrichtung nach einem der Ansprüche 1 oder 2, wobei die Funkübertragungsvorrichtung (10) gemäß eines zweiten Typs (Typ 2) eines zu übertragenden Abfragesignals (SA2) als Verkehrswarn- und Kollisionsvermeidungssystem zum Übertragen eines 1030 MHz-Abfragesignals konfiguriert ist.

4. Übertragungsvorrichtung nach einem der Ansprüche 1 bis 3, wobei die Vorverzerrungsvorrichtung (203) Folgendes umfasst:
- eine programmierbare Logikschaltung (2031), die in der Lage ist, eine Anpassung einer Phase und einer Amplitude des zu verstärkenden Signals anzusteuern;
- einen Digital-Analog-Wandler (2032) für ein IQ-Signal;
- einen Modulator (2033) für das IQ-Signal mit integriertem Synthesizer.

5. Übertragungsvorrichtung nach Anspruch 4, wobei die programmierbare Logikschaltung (2031) Folgendes umfasst:
- ein Steuermodul (20311), das zur Steuerung der Vorverzerrung angepasst ist;
- ein Vorverzerrungs-Steuermodul (20312);
- ein Amplituden- und Phasenanpassungsmodul (20313).

6. Übertragungsvorrichtung nach Anspruch 5, wobei das Steuermodul (20311) eine Steuerung anhand einer Vielzahl von Parametern wie Frequenz, Leistung und/oder Temperatur durchführt.

7. Verfahren zur Funkübertragung eines Abfragesignals anhand eines zu verstärkenden Signals (Sa1, Sa2), wobei das Abfragesignal (SA1, SA2) eine Vielzahl von Impulsen aufweist, wobei das Verfahren Folgendes aufweist:
- einen Schritt (E1) der Erzeugung eines zu verstärkenden Signals (Sa1, Sa2) und zum Vorverzerren E(11) der Impulse des zu verstärkenden Signals (Sa1, Sa2) auf Trägerfrequenz;
- einen Schritt (E2) der Leistungsverstärkung des zu verstärkenden Signals (Sa1, Sa2), um ein Abfragesignal (SA1, SA2) zu bilden;
- einen Schritt (E3) der Erzeugung eines trapezförmigen Signals (Strapez), das während des Schritts (E2) der Leistungsverstärkung als Polarisationsspannung angelegt wird, um jeden der Impulse des Abfragesignals (SA1, SA2) zu übertragen;
wobei das Funkübertragungsverfahren in einer Übertragungsvorrichtung implementiert wird, die eine einzige Signalverstärkungskette umfasst und ferner Folgendes aufweist:
- einen Schritt (E0) der Auswahl (100) eines zu übertragenden Abfragesignaltyps aus mindestens zwei Typen (Typ 1, Typ 2) von verschiedenen Abfragesignalen, wobei der Schritt (E2) der Leistungsverstärkung des zu verstärkenden Signals so konfiguriert ist, dass die Übertragung eines zu verstärkenden Signals (Sa1, Sa2) zur Erzeugung des Abfragesignals (SA1, SA2) entsprechend dem ausgewählten Abfragesignaltyp (Typ 1, Typ 2) ermöglicht wird.

8. Transponder, eine Funkübertragungsvorrichtung (10) nach einem der Ansprüche 1 bis 6 aufweisend.

9. Flugzeug-Kollisionsvermeidungssystem X, ACAS-X, eine Funkübertragungsvorrichtung (10) nach einem der Ansprüche 1 bis 6 aufweisend.

10. Computerprogrammprodukt, Programmanweisungen aufweisend, die von einer Funkübertragungsvorrichtung (10) verwendet werden können, die dazu angepasst ist, ein Abfragesignal (SA1, SA2) aus einem zu verstärkenden Signal (Sa1, Sa2) nach einem der Ansprüche 1 bis 6 zu übertagen, die, wenn sie durch die Übertragungsvorrichtung (10) ausgeführt oder interpretiert werden, die Umsetzung des Funkübertragungsverfahrens des Abfragesignals (SA1, SA2) nach Anspruch 7 auslösen.

## Claims

1. A radio transmission device (10) for the radio transmission of an interrogation signal (SA1, SA2) based on a signal to be amplified (Sa1, Sa2), said interrogation signal (SA1, SA2) containing a plurality of pulses, said radio transmission device (10) comprising:
- a generator (200) for generating a signal to be amplified (Sa1, Sa2) with a pre-distortion device (203) for pre-distorting the pulses of the signal to be amplified (Sa1, Sa2) on a carrier frequency;
- a single power amplification chain (300) for amplifying the power of the signal to be amplified (Sa1, Sa2) so as to form an interrogation signal (SA1, SA2);
- an interface module (400) able to generate a trapezoidal signal (Strapez) applied as bias voltage in the power amplification chain (300) so as to transmit each of the pulses of said interrogation signal (SA1, SA2); and
- a selection block (100) for selecting a type of interrogation signal to be transmitted from at least two different interrogation signal types (Type 1, Type 2),
said generator (200) for generating a signal to be amplified being configured so as to allow transmission of a signal to be amplified (Sa1, Sa2), so as to generate the interrogation signal (SA1, SA2) corresponding to the selected type (Type 1, Type 2) of interrogation signal.

2. The transmission device according to claim 1, wherein, according to a first type (Type 1) of interrogation signal (SA1) to be transmitted, the radio transmission device (10) is configured as a Mode S transponder for transmitting a 1090 MHz interrogation signal.

3. The transmission device according to any one of claim 1 or 2, wherein, according to a second type (Type 2) of interrogation signal (SA2) to be transmitted, the radio transmission device (10) is configured as a traffic alert and collision avoidance system for transmitting a 1030 MHz interrogation signal.

4. The transmission device according to any one of claims 1 to 3, wherein the pre-distortion device (203) comprises:
- a programmable logic circuit (2031) able to drive an adjustment of a phase and an amplitude of the signal to be amplified,
- a digital-to-analogue converter (2032) for the digital-to-analogue conversion of an IQ signal;
- a modulator (2033) for modulating the IQ signal with an integrated synthesizer.

5. The transmission device according to claim 4, wherein the programmable logic circuit (2031) comprises:
- a control module (20311) adapted to control the pre-distortion;
- a pre-distortion command module (20312);
- an amplitude and phase adjustment module (20313).

6. The transmission device according to claim 5, wherein the control module (20311) performs control based on a plurality of parameters such as a frequency, a power and/or a temperature.

7. A method for the radio transmission of an interrogation signal based on a signal to be amplified (Sa1, Sa2), said interrogation signal (SA1, SA2) containing a plurality of pulses, said method containing:
- a step (E1) of generating a signal to be amplified (Sa1, Sa2) and of pre-distorting E(11) the pulses of the signal to be amplified (Sa1, Sa2) on a carrier frequency;
- a step (E2) of amplifying the power of the signal to be amplified (Sa1, Sa2) so as to form an interrogation signal (SA1, SA2);
- a step (E3) of generating a trapezoidal signal (Strapez) applied as bias voltage during the power amplification step (E2) so as to transmit each of the pulses of said interrogation signal (SA1, SA2);
said radio transmission method being implemented in a transmission device comprising a single signal amplification chain and further containing:
- a step (E0) of selecting (100) a type of interrogation signal to be transmitted from among at least two different types (Type 1, Type 2) of interrogation signals, the step (E2) of amplifying the power of the signal to be amplified being configured so as to allow transmission of a signal to be amplified (Sa1, Sa2) so as to generate the interrogation signal (SA1, SA2) corresponding to the selected type (Type 1, Type 2) of interrogation signal.

8. A transponder comprising a radio transmission device (10) according to any one of claims 1 to 6.

9. An Airborne Collision Avoidance System X (ACAS-X), containing a radio transmission device (10) according to any one of claims 1 to 6.

10. A computer program-product containing program instructions able to be utilised by a radio transmission device (10) designed to transmit an interrogation signal (SA1, SA2) based on a signal to be amplified (Sa1, Sa2) according to any one of claims 1 to 6, which instructions, when they are executed or interpreted by said transmission device (10), trigger the implementation of the method for the radio transmission of the interrogation signal (SA1, SA2) according to claim 7.
